# FASCICULE DE BREVET EUROPEEN

(11) **EP 3 127 142 B1**
(45) Date de publication et mention de la délivrance du brevet: **07.02.2024**
(21) Numéro de dépôt: 15712173.2
(22) Date de dépôt: 27.03.2015
(51) Int. Cl.: H01L 21/02, H01L 29/04, H01L 21/763, H01L 21/762, H01L 21/20

(54) **PROCÉDÉ DE FABRICATION D'UNE PLAQUE DE SEMI-CONDUCTEUR ADAPTÉE POUR LA FABRICATION D'UN SUBSTRAT SOI, ET PLAQUE DE SUBSTRAT SOI AINSI OBTENUE**
VERFAHREN ZUR HERSTELLUNG EINES HALBLEITERWAFERS ZUR HERSTELLUNG EINES SOI-SUBSTRATS UND DAMIT HERGESTELLTER SOI-SUBSTRATWAFER
METHOD FOR MANUFACTURE OF A SEMICONDUCTOR WAFER SUITABLE FOR THE MANUFACTURE OF AN SOI SUBSTRATE, AND SOI SUBSTRATE WAFER THUS OBTAINED

(30) Priorité: 31.03.2014 FR 1452845
(43) Date de publication de la demande: 08.02.2017
(73) Titulaire: STMicroelectronics SA, 92120 Montrouge (FR)
(72) Inventeur: DUTARTRE, Didier, 38240 Meylan (FR); JAOUEN, Hervé, 38330 Saint Nazaire Les Eymes (FR)
(74) Mandataire: Casalonga
(86) Numéro de dépôt international: PCT/EP2015/056719
(87) Numéro de publication internationale: WO 2015/150257

(56) Documents cités:
- US-A1- 2012 202 327
- US-A1- 2013 084 689
- US-A1- 2014 038 388
- US-A1- 2014 084 290
- US-B1- 7 868 419

## Description

L'invention concerne le domaine de l'électronique et plus précisément celui des substrats semi-conducteurs permettant la fabrication de circuits électroniques, notamment dédiés à des applications radio-fréquence.

En particulier, des modes de mise en oeuvre et de réalisation de l'invention ont trait à un procédé de réalisation d'une structure de type silicium sur isolant, également appelée structure « SOI » en anglais pour « Silicon On Insulator » et à une telle structure.

Un substrat de type SOI comprend classiquement un film semiconducteur (ou couche semi-conductrice supérieure) situé au dessus d'une couche isolante enterrée (d'oxyde de silicium en général), couramment désignée sous l'acronyme BOX (d'après l'anglais Burried OXide), elle-même située au dessus d'un substrat porteur, par exemple un substrat massif.

Les circuits intégrés radiofréquence (RF) performants sont généralement fabriqués sur des substrats semi-conducteurs dopés P de type dit « HR », c'est-à-dire de haute résistivité (typiquement supérieur à 1 kOhm.cm), de manière à limiter les pertes dans le substrat et la diaphonie (« cross-talk ») entre composants voisins, par conduction.

Il est en outre courant de recourir à des substrats HR de type SOI (Silicon On Insulator). Les composants passifs ou actifs formés dans et sur la couche semiconductrice supérieure sont alors isolés du substrat massif par la couche d'oxyde enterrée.

Cependant, il a été observé que recourir à de tels substrats réduit les pertes liées au substrat sans totalement les supprimer. En effet, des charges électriques fixes positives sont inévitablement présentes dans le BOX du fait du procédé de fabrication de cette couche d'oxyde. Elles sont responsables de l'accumulation dans le substrat, au voisinage du BOX, de charges électriques mobiles (électrons) pouvant former un canal conducteur. Ainsi, bien que l'on ait recours à des substrats de type HR, la conduction parasite de surface dans le substrat est la source de pertes Joule par courants de Foucault.

L'empilement Silicium isolé / BOX / Substrat se comporte en outre comme une capacité MOS (Métal Oxide Semiconductor). En première approximation, on considère que l'épaisseur de la couche d'inversion associée à cette capacité MOS évolue inversement avec la racine carrée de la concentration en dopant du substrat. On conçoit donc que cette épaisseur est d'autant plus importante que le substrat est de type HR, c'est-à-dire à faible dopage. Cette capacité présente la caractéristique d'être modulée par le potentiel électrique appliqué aux composants formés dans ou sur le film de silicium isolé, en regard et au-dessus du BOX. Cette capacité parasite modulée est responsable de distorsions harmoniques et de diaphonie affectant les composants RF des circuits intégrés, de manière préjudiciable pour les performances de ces composants. Une telle distorsion peut en particulier être quantifiée par la méthode de détermination du point d'interception du troisième ordre, ou en anglais « Third order intercept point », abrégé en TOIP ou IP3.

Afin de remédier à ce phénomène, il est connu d'utiliser des structures de substrat porteur plus complexes, intégrant une région spécifique séparant la partie monocristalline du substrat porteur et le BOX de manière à créer, à proximité du BOX, une densité élevée d'états de surface susceptibles de piéger les porteurs libres. Ce piégeage des porteurs libres par les états de surface réduit fortement le phénomène de conduction parasite de surface. Il provoque en outre un ancrage du niveau de Fermi dans le semi-conducteur, à l'interface substrat-BOX (« Fermi level pinning »), ce qui rend la valeur de la capacité MOS parasite largement indépendante du potentiel électrique appliqué aux composants formés en regard, au-dessus du BOX, limitant ainsi les distorsions harmoniques. De tels substrats sont qualifiés de « trap-rich ».

Le document "SOI technology: An Opportunity for RF Designers, Journal of 30 Télécommunications and Information Technology, 04/2009" décrit une méthode particulièrement efficace pour former une couche riche en pièges (trap-rich) sous le BOX d'un substrat SOI, consistant à former un substrat porteur comportant une couche de silicium polycristallin (couramment désigné par le terme « polysilicium ») intercalée entre la partie monocristalline du substrat porteur et le BOX. Les discontinuités de l'arrangement cristallin au niveau de joints de grains du polysilicium se comportent en effet comme des pièges à charges. Une telle couche peut être formée par le dépôt sur le substrat monocristallin, avant la formation du BOX, d'une couche de silicium polycristallin ou amorphe, par un dépôt chimique en phase vapeur basse pression (dit dépôt LPCVD, pour Low Pressure Chemical Vapor Déposition) ou assisté par plasma (dit dépôt PECVD, pour Plasma Enhanced Chemical Vapor Déposition), dépôt suivi d'un recuit de recristallisation et/ou de stabilisation. Afin de bien obtenir une couche polycristalline et non une simple épitaxie à partir du substrat monocristallin, il est nécessaire de former sur ce dernier, préalablement au dépôt de silicium, une couche d'interface bloquant la croissance épitaxiale. Une couche d'oxyde de silicium de moins d'un nanomètre d'épaisseur, obtenue par oxydation chimique ou thermique, est pour cela suffisante.

Le document US 2014/038388 A1 décrit une méthode pour former une couche riche en pièges sous une couche d'oxyde d'un substrat SOI, consistant à former plusieurs couches de silicium polycristallin s'alternant avec des couches de découplage ('decoupling layers'). Les documents US 2013/084689 A1 et US 2012/202327 A1 décrivent des autres structures d'un substrat SOI.

Afin d'augmenter la densité de pièges, il est souhaitable d'augmenter la densité de joints de grains à l'interface polysilicium-BOX, c'est-à-dire de diminuer la largeur moyenne des grains à cet interface. Les inventeurs ont malheureusement constaté que la croissance du polysilicium obtenue par dépôt CVD est de type pseudo-colonnaire « divergente", c'est-à-dire que les grains ont sensiblement la forme de cônes inversés, allant en s'évasant entre la base de la couche et son sommet. La largeur moyenne des grains est donc maximale au sommet de la couche de polysilicium, c'est-à-dire à l'interface polysilicium-BOX, et donc la densité surfacique de pièges à cette interface n'est pas optimale.

Or, afin d'éloigner suffisamment la partie monocristalline du substrat porteur du BOX et des composants réalisés sur la couche fine située au-dessus du BOX, la couche de polysilicium doit présenter une épaisseur minimale de 1000nm à 5000nm et la largeur moyenne des grains de polysilicium à l'interface polysilicium-BOX qui en résulte est alors de l'ordre de 200nm à 1000nm. Pour des composants RF en technologie 90nm ou 65nm ou inférieure, cela signifie donc que la largeur moyenne des grains de polysilicium à l'interface avec le BOX est supérieure à la dimension latérale des transistors élémentaires au-dessus du BOX. Ainsi, en fonction de l'emplacement des composants au-dessus du BOX, par exemple des transistors, ces derniers peuvent se trouver soit à l'aplomb d'un grain unique, ou de plusieurs grains, et ce de façon aléatoire. Il s'ensuit une dispersion des paramètres électriques des transistors, la densité de pièges sous un transistor dépendant de sa position vis-à-vis des grains.

Les inventeurs ont constaté que former la couche de silicium polycristallin par recristallisation contrôlée d'une couche de silicium amorphe ne permet pas de réduire sensiblement la taille moyenne des grains de polysilicium à l'interface polysilicium- BOX. En effet, un budget thermique minimum est nécessaire pour stabiliser suffisamment un substrat multicouche et le rendre thermo-mécaniquement stable et apte à servir de substrat de départ pour la fabrication de circuits intégrés. Ce budget thermique conduit à une couche de polysilicium dont la taille de grains est égale ou supérieure à celle obtenue en déposant directement une couche polycristalline sur le substrat massif.

Il existe donc un besoin d'une méthode de fabrication de substrat de type SOI palliant tout ou partie des inconvénients ci-dessus.

Selon un mode de mise en oeuvre et de réalisation il est proposé un procédé de réalisation d'un substrat du type SOI permettant notamment d'améliorer le piégeage de charges électriques au niveau de l'interface entre la couche d'isolant électrique (BOX) et le substrat porteur du substrat de type SOI.

Selon un aspect il est proposé un procédé de réalisation d'un substrat du type silicium sur isolant comportant une réalisation d'un substrat porteur et une réalisation d'un film semiconducteur situé au-dessus d'une couche isolante enterrée elle-même située au-dessus du substrat porteur.

Selon cet aspect la réalisation du substrat porteur comprend une réalisation, sur une face d'un support semiconducteur, d'un empilement situé entre ledit support semiconducteur et ladite couche isolante enterrée et comportant au moins une structure initiale.

La réalisation de ladite structure initiale comporte les étapes revendiquées de la revendication 1.

La formation de ces couches et zones d'interfaces empilées est donc avantageusement effectuée de façon successive en partant d'un et en utilisant un même support, à savoir en partant dudit et en utilisant ledit même support semiconducteur.

Selon un mode de mise en oeuvre, la formation de la zone d'interface comprend une exposition de la face supérieure de la première couche à un environnement oxydant pour oxyder ladite face supérieure.

En variante la formation de la zone d'interface comprend une amorphisation de la face supérieure de ladite première couche.

La réalisation dudit empilement peut comprendre en outre une réalisation d'au moins une structure supplémentaire sur ladite deuxième couche comportant une réalisation d'une nouvelle zone d'interface surmontée par une nouvelle couche de matériau semi-conducteur polycristallin, de façon à former un empilement de plusieurs couches d'un matériau semi-conducteur polycristallin, les couches de matériau semi-conducteur polycristallin étant respectivement séparées par des zones d'interface présentant une structure distincte de la structure cristalline desdites couches de matériau semi-conducteur polycristallin.

Selon l'invention, la dernière couche de matériau semi-conducteur polycristallin dudit empilement présente une épaisseur inférieure à 20% de l'épaisseur totale des couches de matériau semi-conducteur polycristallin dudit empilement.

Selon un autre aspect, il est proposé un substrat du type silicium sur isolant, comprenant un film semi-conducteur situé au-dessus d'une couche isolante enterrée elle-même située au-dessus d'un substrat porteur.

Selon cet aspect le substrat porteur comporte un support semi-conducteur et un empilement situé entre une face du support semiconducteur et ladite couche isolante enterrée.

Ledit empilement comporte les caractéristiques de la revendication 5, et notamment il comporte au moins une structure initiale incluant une première couche de matériau semi-conducteur polycristallin en contact avec ladite face du support semi-conducteur et une deuxième couche de matériau semi-conducteur polycristallin, ladite seconde couche étant séparée de la première couche par une zone d'interface présentant une structure distincte de la structure cristalline de ladite première couche.

L'épaisseur de la deuxième couche peut être comprise entre 100nm et 300nm.

Selon un mode de réalisation, le substrat peut comprendre en outre au moins une structure supplémentaire sur ladite deuxième couche comportant une nouvelle zone d'interface surmontée par une nouvelle couche de matériau semi-conducteur polycristallin, de façon à former un empilement de plusieurs couches de matériau semi-conducteur polycristallin respectivement séparées par des zones d'interface présentant une structure distincte de la structure cristalline desdites couches de matériau polycristallin.

La dernière couche de matériau semi-conducteur polycristallin de l'empilement présente une épaisseur inférieure à 20% de l'épaisseur totale des couches de matériau semi-conducteur polycristallin de l'empilement.

Certains aspects de l'invention seront mieux compris à la lecture de la description qui suit, donnée uniquement à titre d'exemple, et réalisée en relation avec les figures annexées, dans lesquelles :
- les figures 1 à 4 et 6 sont des schémas simplifiés d'une vue de côté partielle d'une plaque de semi-conducteur formant un substrat porteur d'un substrat de type SOI, au fur et à mesure de sa fabrication;
- la figure 5 est un schéma simplifié d'une vue de côté d'une variante de réalisation d'une telle plaque de semiconducteur.

Bien entendu, pour faciliter la compréhension, les différents éléments représentés aux figures, et en particulier les couches composant les plaques de matériau semiconducteur ont été représentés schématiquement, et les proportions de ces différents éléments peuvent s'écarter des proportions réelles.

La description ci-dessous expose notamment un exemple de procédé de réalisation d'une plaque de semiconducteur formant un substrat porteur d'un substrat de type SOI, et certaines variantes de réalisation, et expose certains effets et avantages liés à la constitution d'une telle plaque.

Pour ne pas gêner la compréhension, seules les étapes importantes pour la réalisation d'une telle plaque seront détaillées, étant entendu que l'homme du métier mettra en oeuvre les techniques classiques liées aux opérations de préparation de lavage, de finition, ou autres, sans qu'il soit nécessaire de les décrire ici en détail.

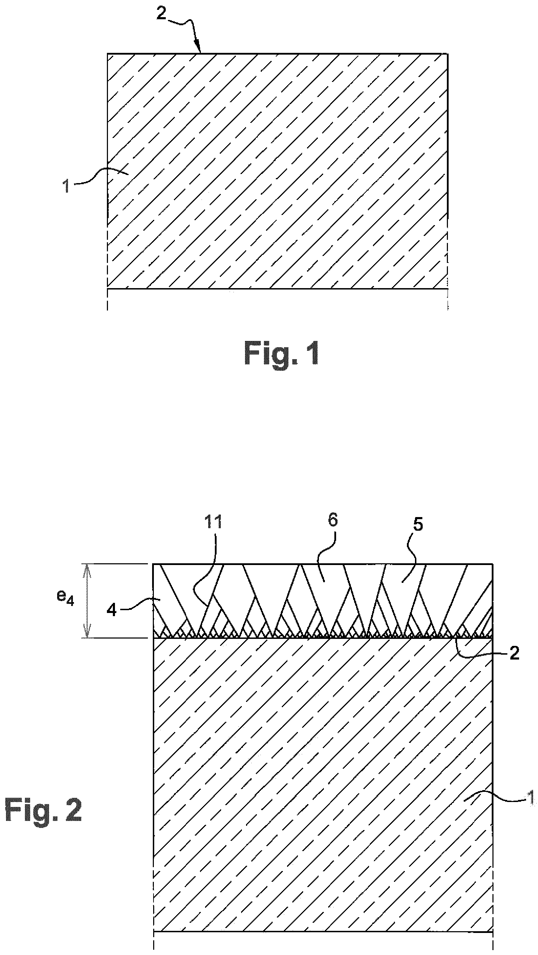

Le procédé débute par la préparation d'un support de base en matériau semi-conducteur, également appelé « wafer » en anglais, tel qu'illustré à la figure 1. Ce support 1 peut être réalisé à partir de tout matériau semi-conducteur, et en particulier à base de silicium. Ainsi, dans la suite de la description, le matériau de base semi-conducteur sera décrit comme étant du silicium, étant entendu qu'il pourrait être remplacé par n'importe quel autre matériau semi-conducteur connu, et en particulier du germanium ou de l'arséniure de gallium.

Le mode de réalisation décrit ici présente un avantage particulier pour les supports semi-conducteur à haute résistivité, c'est-à-dire à relativement faible dopage, et qui présente typiquement une résistivité supérieure à 1 kOhm.cm. Ce type de substrat est en particulier apprécié pour la réalisation de composants radio-fréquence.

Ainsi, dans une première étape, la face supérieure 2 du substrat 1 est préparée pour permettre un dépôt d'une couche de polysilicium. Puis, comme illustré à la figure 2, une première couche 4 de polysilicium est formée sur la face supérieure 2 du support semiconducteur 1. Plus précisément, cette première couche 4 est déposée sur la face supérieure 2 du support 1 par une technique de dépôt chimique en phase vapeur, de sorte à former une couche 4, dont l'épaisseur e₄ est comprise typiquement entre 500 nanomètres et 5 000 nanomètres, de préférence entre 1000 nanomètres et 2000 nanomètres, (l'épaisseur e₄ est définie selon une direction normale à l'interface entre deux couches). Eventuellement, après son dépôt, la première couche 4 peut subir un traitement thermique adapté à son épaisseur et à sa nature, de sorte à stabiliser sa structure en la cristallisant. Compte-tenu de l'état de surface de la couche de substrat 1 avant ce dépôt, les atomes de silicium s'organisent selon les arrangements cristallins locaux, donnant une structure pseudo-colonnaire divergente, avec des grains 5,6 de forme sensiblement pyramidale s'évasant vers le haut, comme illustré schématiquement à la figure 2. Des opérations de traitement thermique peuvent modifier les grains et le regroupement de certains grains en grains de taille plus importante.

Bien entendu, d'autres techniques de dépôt peuvent être employées pour former cette première couche et par exemple des dépôts chimiques en phase vapeur à basse pression (LPCVD), ou plus généralement par tout type de technique de dépôt connue pour permettre la réalisation de couches de polysilicium.

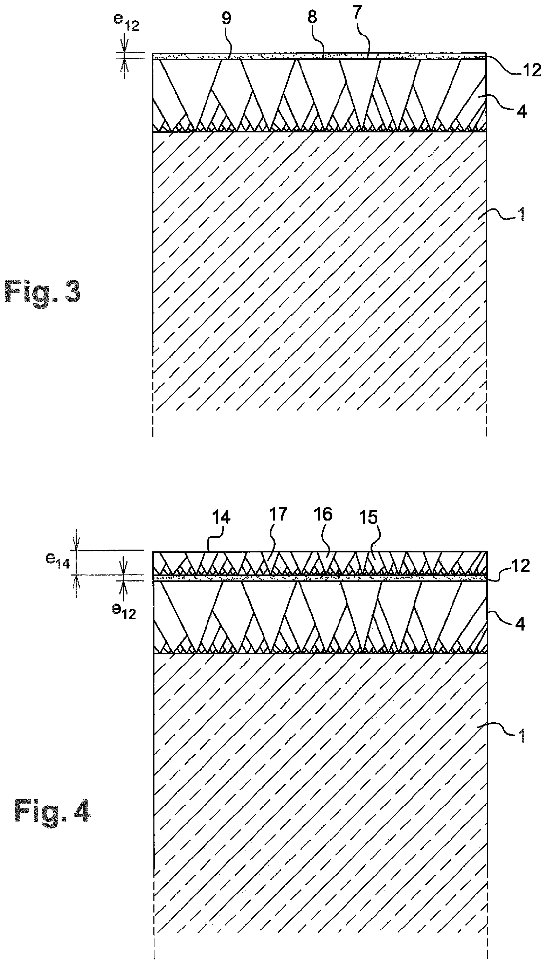

Selon une étape ultérieure illustrée à la figure 3, un traitement de surface peut être réalisé pour créer une zone d'interface 12 sur laquelle sera déposée une nouvelle couche de polysilicium.

En effet, la face supérieure 7 de la première couche de polysilicium 4 se découpe en différentes régions 8, 9 appartenant chacune à un grain distinct, et qui présentent chacune une structure cristalline régulière. Un dépôt de silicium qui interviendrait directement sur cette face 7 se traduirait par une croissance épitaxiale qui prolongerait la croissance des grains de la couche sous-jacente. Or, un des objectifs évoqué est d'augmenter la densité des joints 11 entre grains, donc de conserver des grains de petite taille. Pour éviter une croissance épitaxiale, la deuxième étape comprend la formation d'une zone d'interface à la surface 7 de la première couche 4 de polysilicium, ce qui permettra la croissance d'une nouvelle couche de polysilicium sans reprise épitaxiale et donc avec un maximum de grains distincts.

Pour ce faire, différentes techniques peuvent être employées. Il est ainsi possible d'exposer la face supérieure 7 de la première couche 4 de polysilicium à un environnement comprenant des espèces oxydantes. Cette oxydation peut être obtenue simplement par exposition du wafer, encore suffisamment chaud suite au dépôt de la première couche de polysilicium 4, à l'atmosphère ambiante, ou à une atmosphère contrôlée, incluant une fraction d'oxygène. Les phénomènes d'oxydation naturelle créent à la surface 7 de la couche 4 de polysilicium, une couche 12 de très faible épaisseur e₁₂ de l'ordre de grandeur du nanomètre, qui présente une structure distincte de la structure cristalline des grains de polysilicium (l'épaisseur e₁₂ qui est représentée à la figure 3 est bien entendu exagérée pour en permettre sa visualisation). Cette oxydation peut aussi être réalisée par une oxydation thermique contrôlée de type RTO (de l'anglais Rapid Thermal Oxidation), c'est-à-dire une oxydation dont la cinétique est augmentée par chauffage de la plaque, typiquement entre 600 et 900°C, en présence d'une atmosphère oxydante.

Il est également possible de réaliser cette oxydation en procédant à un traitement chimique oxydant selon des modes opératoires classiques.

Parmi les autres possibilités de réalisation de la zone d'interface 12, on peut citer des opérations d'implantation ionique d'espèces non-dopantes, telles que l'argon, le germanium ou tout autre ion lourd convenant. Un tel bombardement ionique permet d'amorphiser, au moins partiellement, la surface 7 de la couche polycristalline 4, c'est-à-dire de rompre l'arrangement cristallin à la surface des grains, ce qui permet d'éviter une croissance épitaxiale lors du dépôt d'une nouvelle couche de polysilicium.

Dans une étape ultérieure, illustrée à la figure 4, une deuxième couche 14 de silicium est déposée sur la zone d'interface 12. Cette deuxième couche 14 peut avantageusement être réalisée d'une manière identique à celle décrite pour la réalisation de la couche 4, et permet ainsi de former une deuxième couche 14 d'une épaisseur e₁₄, typiquement de l'ordre de quelques dizaines à quelques centaines de nanomètres, de préférence entre de l'ordre de 100 à 300 nm.

Du fait que la croissance de la couche 14 se réalise à partir d'une zone d'interface amorphe, ou déstructurée comme expliqué ci-avant, les cristaux de la deuxième couche de polysilicium ne se forment pas par épitaxie à partir des cristaux de la première couche 4. En d'autres termes, la face supérieure de la première couche 4 est déstructurée, de sorte que les cristaux de la première couche 4 ne se prolongent pas et ne grandissent pas dans la deuxième couche. On observe ainsi l'apparition de grains 15, 16 de polysilicium, qui sont de petite taille dans la région la plus proche de la zone d'interface 12. Il en résulte globalement l'augmentation de la concentration volumique de joints de grain, c'est-à-dire de frontières 17 entre les différents grains de polysilicium, dans toute la région située au-dessus de la couche de substrat monocristallin (support semi-conducteur) 1. Cette concentration volumique élevée en joints de grain permet d'augmenter nettement la densité de pièges de charge dans la région qui sera située en-dessous du BOX. On notera ici que l'interface 12 a une fonction similaire à l'interface 2, précédemment citée.

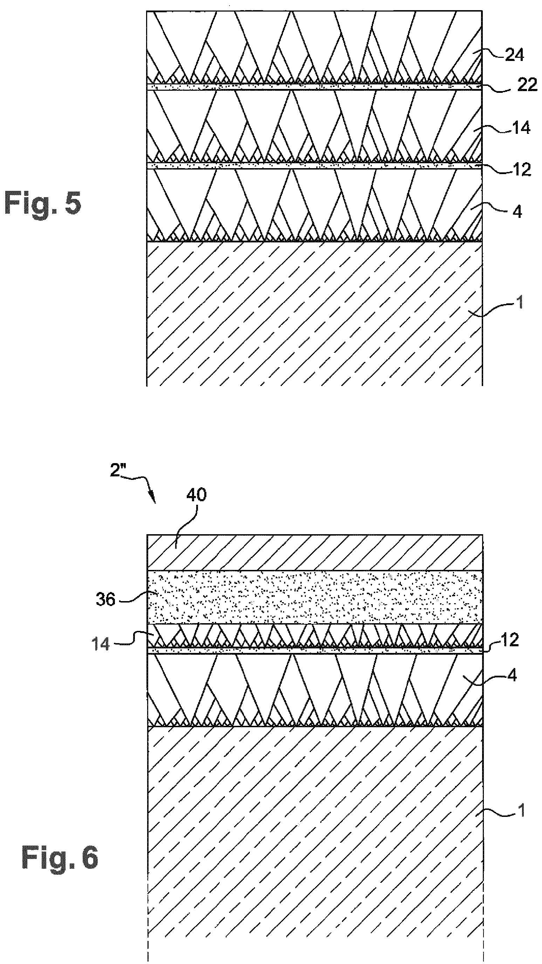

A ce stade, comme illustré sur la figure 4, on a formé un substrat porteur d'un substrat SOI comportant un support semi-conducteur 1 et un empilement situé sur la face 2 du support semiconducteur 1 et destiné comme on le verra en référence à la figure 6 à être situé entre la face 2 du support et la couche isolante enterrée (BOX) du substrat SOI.

Ledit empilement comporte ici une structure initiale incluant la première couche 4 de matériau semi-conducteur polycristallin en contact avec ladite face 2 du support semi-conducteur et la deuxième couche 14 de matériau semi-conducteur polycristallin, ladite deuxième couche 14 étant séparée de la première couche 4 par la zone d'interface 12 présentant une structure distincte de la structure cristalline de ladite première couche.

A titre de variante, il est possible, comme illustré à la figure 5, de répéter l'opération de dépôt d'une couche de polysilicium supplémentaire 24, au-dessus d'une nouvelle zone d'interface 22 fonctionnellement analogue à la zone d'interface 12.

Comme on le voit sur cette figure 5, la structure supplémentaire comportant la nouvelle zone d'interface 22 surmontée par la nouvelle couche de matériau semi-conducteur polycristallin 24, conduit à la formation d'un empilement de plusieurs couches 4, 14, 24 de matériau semi-conducteur polycristallin respectivement séparées par des zones d'interface 12, 22 présentant une structure distincte de la structure cristalline desdites couches 4, 14, 24 de matériau polycristallin.

Bien entendu, le nombre de couches de polysilicium superposées peut être multiplié si l'on souhaite augmenter encore la concentration volumique en joints de grains. On notera que plus l'épaisseur de chacune de ces zones de polysilicium est réduite, plus la densité en joints de grains de la couche est élevée, compte-tenu de la croissance pyramidale inversée du polysilicium.

Il est également envisageable de sélectionner l'épaisseur individuelle de chacune des couches de polysilicium pour assurer une variation prédéterminée de la concentration volumique en joints de grains en fonction de la distance par rapport au BOX. Selon l'invention, l'épaisseur de la dernière couche de polysilicium formant l'empilement est inférieure à 20% de l'épaisseur totale dudit empilement de couches polysilicium.

Par la suite, et comme illustré à la figure 6, le wafer ainsi obtenu (substrat porteur) 1, 4, 12, 14 peut être complété par des techniques connues en vue de réaliser un substrat 2" de type SOI comportant le film semiconducteur 40 situé au dessus de la couche isolante enterré (BOX) 36. Ainsi notamment, comme la rugosité des dépôts épais de polysilicium peut être incompatible avec le procédé de collage moléculaire employé pour reporter le film de silicium isolé, l'empilement sera avantageusement aplani, par exemple par polissage mécanochimique (CMP). On peut aussi citer à titre d'exemple la possibilité de réaliser au-dessus de la dernière couche de polysilicium 14 caractéristique une couche d'oxyde 36 sur laquelle sera ensuite rapporté par collage moléculaire le film monocristallin 40 qui constituera la couche fine (film semiconducteur) du substrat SOI. Il est également possible que la couche d'isolant 36 (BOX) du substrat SOI soit réalisée sur un wafer distinct, puis rapporté par collage moléculaire avec la couche fine monocristalline sur une couche d'oxyde analogue réalisée au-dessus de la dernière couche de silicium polycristallin. D'autres techniques d'achèvement de la structure SOI peuvent être employées sur la structure de base (substrat porteur) décrite ci-avant, comportant un substrat monocristallin sur lequel sont empilées au moins deux couches de silicium polycristallin.

Il ressort de ce qui précède qu'un substrat SOI réalisé comme décrit ci-avant permet de diminuer le phénomène de conduction parasite de surface dans le substrat monocristallin, dans la zone située en-dessous du BOX, y compris dans le cas où il s'agit d'un substrat de haute résistivité La forte concentration en joints de grains permet en effet d'augmenter la résistivité effective du semi-conducteur. Elle permet en outre de limiter la modulation potentielle de la capacité parasite créée par le BOX et le substrat sous-jacent, vis-à-vis de la polarisation appliquée aux composants électroniques formés sur le substrat SOI. Complémentairement, du fait de la réduction de la taille des grains de la région située sous le BOX, on augmente le nombre de grains présents sous les différents composants réalisés dans la couche fine (film semiconducteur) du substrat SOI, et on limite le risque de dispersion d'un composant à l'autre.

## Revendications

1. Procédé de réalisation d'un substrat du type silicium sur isolant comportant une réalisation d'un substrat porteur et une réalisation d'un film semiconducteur (40) situé au-dessus d'une couche isolante enterrée (36) elle-même située au-dessus du substrat porteur (1, 4, 12, 14), dans lequel la réalisation du substrat porteur comprend une réalisation, sur une face (2) d'un support semiconducteur (1), d'un empilement situé entre ledit support semiconducteur et ladite couche isolante enterrée et comportant au moins une structure initiale (4, 12, 14), la réalisation de ladite structure initiale comportant les étapes successives suivantes :
- réalisation, sur ladite face (2) dudit support semi-conducteur (1), par croissance pyramidale inversée, d'une première couche (4) de matériau semi-conducteur polycristallin;
- formation d'une zone d'interface (12) sur la face supérieure (7) de ladite première couche (4), ladite zone d'interface (12) présentant une structure distincte de la structure cristalline de ladite première couche (4) ;
- réalisation sur ladite zone d'interface (12), par croissance pyramidale inversée, d'une deuxième couche (14) de matériau semi-conducteur polycristallin,
la dernière couche de matériau semi-conducteur polycristallin dudit empilement présentant une épaisseur réduite et inférieure à 20% de l'épaisseur totale des couches de matériau semi-conducteur polycristallin dudit empilement, de façon à élever la densité enjoints de grains de ladite dernière couche, compte tenu de la croissance pyramidale inversée du matériau semiconducteur polycristallin.

2. Procédé selon la revendication 1, dans lequel la formation de la zone d'interface (12) comprend une exposition de la face supérieure (7) de la première couche (4) à un environnement oxydant pour oxyder ladite face supérieure.

3. Procédé selon la revendication 1, dans lequel la formation de la zone d'interface (12) comprend une amorphisation de la face supérieure (7) de ladite première couche (4).

4. Procédé selon l'une des revendications 1 à 3, dans lequel la réalisation dudit empilement comprend en outre une réalisation d'au moins une structure supplémentaire (22, 24) sur ladite deuxième couche (14) comportant une réalisation d'une nouvelle zone d'interface (22) surmontée par une nouvelle couche de matériau semi-conducteur polycristallin (24), de façon à former un empilement de plusieurs couches d'un matériau semi-conducteur polycristallin (4, 14, 24), les couches de matériau semi-conducteur polycristallin (4, 14, 24) étant respectivement séparées par des zones d'interface (12, 22) présentant une structure distincte de la structure cristalline desdites couches de matériau semiconducteur polycristallin.

5. Substrat du type silicium sur isolant, comprenant un film semiconducteur (40) situé au-dessus d'une couche isolante enterrée (36) elle-même située au-dessus d'un substrat porteur (1, 4, 12, 14), dans lequel le substrat porteur comporte un support semi-conducteur (1) et un empilement situé entre une face (2) du support semiconducteur (1) et ladite couche isolante enterrée (36) et comportant au moins une structure initiale (4, 12, 14) incluant une première couche (4) de matériau semi-conducteur polycristallin, présentant une structure pyramidale inversée, en contact avec ladite face (2) du support semi-conducteur (1) et une deuxième couche (14) de matériau semi-conducteur polycristallin, présentant une structure pyramidale inversée, ladite seconde couche étant séparée de la première couche (4) par une zone d'interface (12) présentant une structure distincte de la structure cristalline de ladite première couche (4), la dernière couche de matériau semi-conducteur polycristallin dudit empilement présentant une épaisseur réduite et inférieure à 20% de l'épaisseur totale des couches de matériau semi-conducteur polycristallin dudit empilement, de façon à élever la densité en joints de grains de ladite dernière couche, compte tenu de sa structure pyramidale inversée.

6. Substrat selon la revendication 5, comprenant en outre au moins une structure supplémentaire (22, 24) sur ladite deuxième couche comportant une nouvelle zone d'interface (22) surmontée par une nouvelle couche de matériau semi-conducteur polycristallin (24), de façon à former un empilement de plusieurs couches (4, 14, 24) de matériau semi-conducteur polycristallin respectivement séparées par des zones d'interface (12, 22) présentant une structure distincte de la structure cristalline desdites couches (4, 14, 24) de matériau polycristallin.

7. Substrat SOI selon l'une des revendications 5 ou 6, dans laquelle l'épaisseur de la deuxième couche (14) est comprise entre 100nm et 300nm.

## Patentansprüche

1. Verfahren zum Herstellen eines Silizium-auf-Isolator-Substrats, enthaltend das Herstellen eines Trägersubstrats und das Herstellen eines Halbleiterfilms (40), der sich auf einer vergrabenen Isolierschicht (36) befindet, die sich selbst auf dem Trägersubstrat (1, 4, 12, 14) befindet, wobei das Herstellen des Trägersubstrats das Herstellen eines Stapels, der sich zwischen dem Halbleiterträger und der vergrabenen Isolierschicht befindet und mindestens eine Ausgangsstruktur (4, 12, 14) enthält, auf einer Seite (2) eines Halbleiterträgers (1) umfasst, wobei das Herstellen der mindestens einen Ausgangsstruktur die folgenden aufeinanderfolgenden Schritte enthält:
- Herstellen einer ersten Schicht (4) aus einem polykristallinen Halbleitermaterial auf der Seite (2) des Halbleiterträgers (1) durch umgekehrtes pyramidenförmiges Wachstum;
- Bilden einer Grenzflächenzone (12) auf der Oberseite (7) der ersten Schicht (4), wobei die Grenzflächenzone (12) eine Struktur aufweist, die sich von der kristallinen Struktur der ersten Schicht (4) unterscheidet;
- Herstellen einer zweiten Schicht (14) aus einem polykristallinen Halbleitermaterial auf der Grenzflächenzone (12) durch umgekehrtes pyramidenförmiges Wachstum,
wobei die letzte Schicht aus dem polykristallinen Halbleitermaterial des Stapels eine Dicke aufweist, die reduziert und kleiner als 20 % der Gesamtdicke der Schichten aus dem polykristallinen Halbleitermaterial des Stapels ist, so dass die Korngrenzendichte der letzten Schicht unter Berücksichtigung des umgekehrten pyramidenförmigen Wachstums des polykristallinen Halbleitermaterials erhöht wird.

2. Verfahren nach Anspruch 1, wobei das Bilden der Grenzflächenzone (12) das Aussetzen der Oberseite (7) der ersten Schicht (4) einer oxidierenden Umgebung umfasst, um die Oberseite zu oxidieren.

3. Verfahren nach Anspruch 1, wobei das Bilden der Grenzflächenzone (12) das Amorphisieren der Oberseite (7) der ersten Schicht (4) umfasst.

4. Verfahren nach einem der Ansprüche 1 bis 3, wobei das Herstellen des Stapels ferner das Herstellen mindestens einer zusätzlichen Struktur (22, 24) auf der zweiten Schicht (14) umfasst, enthaltend das Herstellen einer neuen Grenzflächenzone (22), die von einer neuen Schicht aus einem polykristallinen Halbleitermaterial (24) überlagert wird, so dass ein Stapel aus mehreren Schichten aus einem polykristallinen Halbleitermaterial (4, 14, 24) gebildet wird, wobei die Schichten aus dem polykristallinen Halbleitermaterial (4, 14, 24) jeweils durch Grenzflächenzonen (12, 22) getrennt sind, die eine Struktur aufweisen, die sich von der kristallinen Struktur der Schichten aus dem polykristallinen Halbleitermaterial unterscheidet.

5. Silizium-auf-Isolator-Substrat, umfassend einen Halbleiterfilm (40), der sich auf einer vergrabenen Isolierschicht (36) befindet, die sich selbst auf einem Trägersubstrat (1, 4, 12, 14) befindet, wobei das Trägersubstrat einen Halbleiterträger (1) und einen Stapel enthält, der sich zwischen einer Seite (2) des Halbleiterträgers (1) und der vergrabenen Isolierschicht (36) befindet und mindestens eine Ausgangsstruktur (4, 12, 14), die eine erste Schicht (4) aus einem polykristallinen Halbleitermaterial, die eine umgekehrte pyramidenförmige Struktur aufweist, die in Kontakt mit der Seite (2) des Halbleiterträgers (1) steht, und eine zweite Schicht (14) aus einem polykristallinen Halbleitermaterial enthält, die eine umgekehrte pyramidenförmige Struktur aufweist, wobei die zweite Schicht von der ersten Schicht (4) durch eine Grenzflächenzone (12) getrennt ist, die eine Struktur aufweist, die sich von der kristallinen Struktur der ersten Schicht (4) unterscheidet, wobei die letzte Schicht aus dem polykristallinen Halbleitermaterial des Stapels eine Dicke aufweist, die reduziert und kleiner als 20 % der Gesamtdicke der Schichten aus dem polykristallinen Halbleitermaterial des Stapels ist, so dass die Korngrenzendichte der letzten Schicht unter Berücksichtigung ihrer umgekehrten pyramidenförmigen Struktur erhöht wird.

6. Substrat nach Anspruch 5, ferner umfassend mindestens eine zusätzliche Struktur (22, 24) auf der zweiten Schicht, die eine neue Grenzflächenzone (22) enthält, die von einer neuen Schicht aus einem polykristallinen Halbleitermaterial (24) überlagert wird, so dass ein Stapel aus mehreren Schichten (4, 14, 24) aus dem polykristallinen Halbleitermaterial gebildet wird, die durch Grenzflächenzonen (12, 22) getrennt sind, die eine Struktur aufweisen, die sich von der kristallinen Struktur der Schichten (4, 14, 24) aus polykristallinem Material unterscheidet.

7. SOI-Substrat nach einem der Ansprüche 5 oder 6, wobei die Dicke der zweiten Schicht (14) zwischen 100 nm und 300 nm beträgt.

## Claims

1. A method for producing a silicon-on-insulator type substrate including a production of a carrier substrate and a production of a semiconductor film (40) located above a buried insulating layer (36) itself located above the carrier substrate (1, 4, 12, 14), wherein the production of the carrier substrate comprises a production, on a face (2) of a semiconductor support (1), of a stack located between said semiconductor support and said buried insulating layer and including at least one initial structure (4, 12, 14), the production of said initial structure including the following successive steps:
- production, on said face (2) of said semiconductor support (1), by inverted pyramid growth, of a first layer (4) of polycrystalline semiconductor material;
- formation of an interface zone (12) on the upper face (7) of said first layer (4), said interface zone (12) having a structure which is distinct from the crystal structure of said first layer (4);
- production on said interface zone (12), by inverted pyramid growth, of a second layer (14) of polycrystalline semiconductor material,
the last layer of polycrystalline semiconductor material of said stack having a thickness which is reduced and less than 20% of the total thickness of the layers of polycrystalline semiconductor material of said stack, so as to raise the grain boundary density of said last layer, taking into account the inverted pyramid growth of the polycrystalline semiconductor material.

2. The method according to claim 1, wherein the formation of the interface zone (12) comprises an exposure of the upper face (7) of the first layer (4) to an oxidising environment to oxidise said upper face.

3. The method according to claim 1, wherein the formation of the interface zone (12) comprises an amorphisation of the upper face (7) of said first layer (4).

4. The method according to one of claims 1 to 3, wherein the production of said stack further comprises a production of at least one additional structure (22, 24) on said second layer (14) including a production of a new interface zone (22) topped by a new layer of polycrystalline semiconductor material (24), so as to form a stack of several layers of a polycrystalline semiconductor material (4, 14, 24), the layers of polycrystalline semiconductor material (4, 14, 24) being respectively separated by interface zones (12, 22) having a structure which is distinct from the crystalline structure of said layers of polycrystalline semiconductor material.

5. A silicon-on-insulator type substrate, comprising a semiconductor film (40) located above a buried insulating layer (36) itself located above a carrier substrate (1, 4, 12, 14), wherein the carrier substrate includes a semiconductor support (1) and a stack located between a face (2) of the semiconductor support (1) and said buried insulating layer (36) and including at least one initial structure (4, 12, 14) including a first layer (4) of polycrystalline semiconductor material, having an inverted pyramid structure, in contact with said face (2) of the semiconductor support (1) and a second layer (14) of polycrystalline semiconductor material, having an inverted pyramid structure, said second layer being separated from the first layer (4) by an interface zone (12) having a structure which is distinct from the crystalline structure of said first layer (4), the last layer of polycrystalline semiconductor material of said stack having a thickness which is reduced and less than 20% of the total thickness of the layers of polycrystalline semiconductor material of said stack, so as to raise the grain boundary density of said last layer, taking into account the inverted pyramid structure thereof.

6. The substrate according to claim 5, further comprising at least one additional structure (22, 24) on said second layer including a new interface zone (22) topped by a new layer of polycrystalline semiconductor material (24), so as to form a stack of several layers (4, 14, 24) of polycrystalline semiconductor material respectively separated by interface zones (12, 22) having a structure which is distinct from the crystalline structure of said layers (4, 14, 24) of polycrystalline material.

7. The SOI substrate according to one of claims 5 or 6, wherein the thickness of the second layer (14) is between 100nm and 300nm.
